(19) Europäisches Patentamt
European Patent Office
Office européen des brevets

(11) **EP 1 858 066 A2**

(12) **EUROPEAN PATENT APPLICATION**

(43) Date of publication:
**21.11.2007 Bulletin 2007/47**

(51) Int Cl.:
*H01L 21/336* (2006.01)          *H01L 29/78* (2006.01)

(21) Application number: **07010043.3**

(22) Date of filing: **21.05.2007**

| | |
|---|---|
| (84) Designated Contracting States:<br>**AT BE BG CH CY CZ DE DK EE ES FI FR GB GR HU IE IS IT LI LT LU LV MC MT NL PL PT RO SE SI SK TR**<br>Designated Extension States:<br>**AL BA HR MK YU** | (72) Inventors:<br>• **Yu, Hong Yu**<br>  **3001 Heverlee (BE)**<br>• **Lousberg, Gregory**<br>  **4342 Hognoul (BE)** |
| (30) Priority: **19.05.2006 US 801956 P** | (74) Representative: **Paemen, Liesbet R.J. et al**<br>**Bird Goen & Co**<br>**Klein Dalenstraat 42A**<br>**3020 Winksele (BE)** |
| (71) Applicant: **Interuniversitair Microelektronica Centrum**<br>**3001 Leuven (BE)** | |

(54) **Semiconductor devices**

(57)     The present invention provides a semiconductor device having first and second electrodes (6) formed in a semiconductor substrate (2) having a doping level, the first and second electrodes (6) being separated from each other by a semiconductor region (5), and a third electrode (3) for controlling conductivity of the semiconductor region (5), at least one of the first and second electrodes (6) forming a rectifying contact with the semiconductor region (5), the rectifying contact having a potential barrier. According to the present invention, the semiconductor region (5) is uniformly doped, at least in a direction between the first and the second electrodes, to have a doping level higher than the doping level of the semiconductor substrate (2) and so as to, in operation, induce an image-force mechanism for lowering the potential barrier of the at least one rectifying contact. The present invention furthermore provides a method for the manufacturing of such semiconductor devices.

**FIG. 9**

**Description**

**Technical field of the invention**

The present invention relates to semiconductor devices comprising metal-semiconductor compound/semiconductor junction regions, e.g. metal-silicide/semiconductor or metal-germanide/semiconductor junction regions. In particular the invention is related to semiconductor devices, such as e.g. field effect transistors, comprising at least one rectifying or Schottky barrier contact used as first and/or second electrodes, e.g. as source/drain electrodes.

**Background of the invention**

Due to scaling down of field-effect transistors well-know components of these transistors have to be replaced by other, more performing, alternatives or substitutes. Highly doped semiconductor regions, also known as source/drain regions, are used to obtain a low ohmic contact towards the interconnect levels and towards the channel and to create a junction between such highly doped regions and the channel for blocking carrier transport when the transistor is in the off-state. However these semiconductor regions tend to be replaced by metallic regions, formed by metallic electrodes. These metallic electrodes directly contact the semiconductor channel thereby forming a metallic-semiconductor junction which is known as a rectifying contact or Schottky barrier junction. Metallic regions offer advantages such a good contact with the interconnect level, low series resistance towards the channel and a low capacitance towards the bulk, because of their shallow and well-defined geometry. For reasons of reduced process complexity these metallic regions are often formed by silicidation of the semiconductor regions at the location of the source and/or drain region.
US patent US 6,495,882 discloses a MOSFET device wherein Schottky barrier contacts are utilized as source and/or drain contacts to eliminate the requirement for halo/pocket implants and shallow source/drain extensions for control of short channel effects.
The thus obtained metallic-semiconductor junction is characterized by a potential barrier, the height of which depends on the properties of the metallic material and of the semiconductor material constituting the junction. If this barrier height is high, i.e. higher than 300 meV, not only will the transistor have a low on-current, being limited by the tunneling of carriers through this high potential barrier, but also they will have a poor sub-threshold behavior. To make field effect transistors having Schottky barrier source/drain regions competing with field effect transistors having state-of-the art highly doped semiconductor source/drain regions, it is expected that the Schottky barrier height should be less than 200 meV for p-type Schottky barrier field effect transistor (SBFET) and less than 150 meV for n-type SBFET. Until now, Platinum silicide and Ytterbium silicide are reported to provide the lowest Schottky barrier height of about 250 meV for respectively p-type SBFET and n-type SBFET.
A lot of attention has been paid to the selection of appropriate silicide-forming metals for manufacturing of source and/or drain regions for n-type and/or p-type field effect transistors. In "Influence of Fermi-level pinning on barrier height inhomogeneity in PtSi/p-Si Schottky contacts", J. Appl. Phys., 69 (2), pp. 850-853, 1991, A. Tanabe et al. disclose the effect of Fermi-level pinning on the barrier height. Although the barrier height can be lowered to some extent by selecting appropriate silicide-forming metals, the Schottky barrier height will remain substantially constant due to the Fermi-level pinning effect occurring at the interface between the silicide region and the silicon channel.
Other approaches have been explored to reduce the Schottky barrier height. In "A new route to zero-barrier metal source/drain MOSFETs", IEEE Trans on Nanotech., 3 (1), pp. 98-104, 2004, D. Connelly et al. disclose the insertion of a thin insulator layer in-between the silicide region and the semiconductor channel.
"Tuning of NiSi1Si Schottky barrier heights by sulfur segregation during Ni silicidation", Appl. Phys. Lett., 86, 062108, 2005, by Q. T. Zhao, et al. and "Effective Schottky barrier lowering in silicon-on-insulator Schottky-barrier metal-oxide-semiconductor field-effect transistors using dopant segregation", Appl. Phys. Len., 87, 263505, 2005 by J. Knoch, et al disclose the creation of a thin highly doped layer at the interface between the silicide region and the silicon channel. This highly doped interfacial layer is created by dopant segregation resulting in a steep doping profile at this interface. Although these approaches modulate the probability for carriers to tunnel through the potential barrier and hence result in an increased on-current of the transistor, their implementation is at the expense of a more complex and costly manufacturing process. Moreover the proposed approach does not offer a solution applicable for n-type and p-type field effect transistors.

**Summary of the invention**

It is an object of embodiments of the present invention to provide good semiconductor devices and a good method for manufacturing such semiconductor devices.
The above objective is accomplished by a method and device according to embodiments of the present invention.
The semiconductor devices according to embodiments of the invention show good short channel behaviour and good performance.

The method according to embodiments of the invention leads to good semiconductor devices, such as Field-effect transistors (SBFETs), with limited process complexity.

The method according to embodiments of the invention leads to a device with high on-current by lowering a potential barrier height of a rectifying contact formed by a metal-semiconductor compound/metal interface, e.g. a silicide/semiconductor or germanide/semiconductor interface, between a first and/or second electrode and a semiconductor region of the device, also referred to as Schottky barrier height. The method according to embodiments of the invention is applicable to the manufacturing of both n-type and p-type semiconductor devices, e.g. field effect transistors.

In a first aspect, the present invention provides a semiconductor device having first and second electrodes formed in a semiconductor substrate having a doping level, the first and second electrodes being separated from each other by a semiconductor region, and a third electrode for controlling conductivity of the semiconductor region, at least one of the first and second electrodes forming a rectifying contact with the semiconductor region, also called a Schottky contact or a Schottky-like contact, the rectifying contact having a potential barrier, wherein the semiconductor region is uniformly doped at least in a horizontal direction between the first and the second electrode, but preferably also in a vertical direction i.e. in a direction perpendicular to the third electrode, so as to have a doping level higher than the doping level of the semiconductor substrate and so as to, in operation, induce an image-force mechanism for lowering the potential barrier of the at least one rectifying contact.

With horizontal direction is meant, when the semiconductor substrate is lying in a plane, in a direction substantially parallel to the plane of the substrate. With direction perpendicular to the third electrode is meant in a direction substantially perpendicular to the plane of the substrate.

An advantage of the semiconductor device according to embodiments of the invention is that its shows good short channel behaviour, good performance and high on-current.

According to embodiments of the invention, the semiconductor device may be a Schottky barrier field-effect transistor (SBFET) comprising a gate electrode isolated from a semiconductor channel by a gate dielectric, source and drain electrodes being aligned to the gate electrode and located at opposite sides of the semiconductor channel. At least one of the source/drain electrodes forms a Schottky contact or Schottky-like contact or rectifying contact with the semiconductor channel. The semiconductor channel is substantially uniformly doped along its length and at least along the depth of the at least one Schottky contact or Schottky-like contact or rectifying contact. The doping level in the semiconductor channel is selected such that, in operation, the potential barrier, also referred to as Schottky barrier, of the at least one Schottky contact or Schottky-like contact or rectifying contact is substantially reduced by an induced image-force mechanism.

Optionally, the doping level of the semiconductor region may be between $1e16$ cm$^{-3}$ and $1\,e18$ cm$^{-3}$. If the uniform channel doping concentration is too low, i.e. substantially below $1e16$ cm$^{-3}$, no substantial image force effect will occur. If the uniform channel doping concentration is too high, i.e. substantially above $1e18$ cm$^{-3}$, the effect of mobility degradation and even short-circuiting of the channel with the source/drain regions at higher channel doping levels will be dominant.

The semiconductor region may have a length and the rectifying contact may have a depth into the semiconductor substrate and the semiconductor region may be uniformly doped along its length and at least along the depth of the rectifying contact.

At least one of the first or second electrode, optionally both the first and the second electrode, may comprise a metal-semiconductor compound.

According to embodiments of the invention, at least one of the first or second electrode, optionally both the first and the second electrode, may comprise a silicide.

According to other embodiments of the invention, at least one of the first or second electrode, optionally both the first and the second electrode, may comprise a germanide.

According to specific examples of the present invention, the semiconductor device may be a p-type semiconductor device. According to these embodiments, at least one of the first and second electrodes may comprise platinum silicide. The semiconductor region may be uniformly doped with one or more dopant elements selected from group V elements.

According to other specific examples of the present invention the semiconductor device may be an n-type semiconductor device. According to these embodiments, at least one of the first and second electrodes may comprise Ytterbium silicide. The semiconductor region may be uniformly doped with one or more dopant elements selected from group III elements.

According to preferred embodiments, the semiconductor substrate may be a silicon substrate.

In a second aspect of the present invention, a method is provided for manufacturing a semiconductor device. The method comprises:

- providing first and second electrodes in a semiconductor substrate separated from each other by a semiconductor region, the semiconductor substrate having a doping level, and

- providing a third electrode (3) for controlling conductivity of the semiconductor region (5), at least one of the first and second electrodes (6) forming a rectifying contact with the semiconductor region (5), the rectifying contact having a potential barrier,

wherein the method furthermore comprises, before providing first, second and third electrodes (6, 5), uniformly doping, at least in a horizontal direction between the first and the second electrode, but preferably also in a vertical direction i.e. in a direction perpendicular to the third electrode, the semiconductor region (5) up to a doping level higher than the doping level of the semiconductor substrate (2) such that, in operation, the potential barrier of the at least one rectifying contact is reduced by inducing an image-force mechanism.

With horizontal direction is meant, when the semiconductor substrate is lying in a plane, in a direction substantially parallel to the plane of the substrate. With direction perpendicular to the third electrode is meant in a direction substantially perpendicular to the plane of the substrate.

An advantage of the method according to embodiments of the invention is that it has limited complexity and it leads to a semiconductor device showing good short channel behaviour, good performance and high on-current.

The method of modulating, in particular reducing, the height of the potential barrier of the at least one rectifying contact by means of an image-force lowering effect according to embodiments of the invention can be easily implemented in state-of-the-art semiconductor manufacturing processes as it relies on conventional CMOS process techniques such as ion implantation to adjust the concentration of dopant elements of the semiconductor region, e.g. channel, to an appropriate level, which is substantially uniform over the channel both in lateral and in vertical direction.

According to embodiments of the invention, the method may be a method for manufacturing a Schottky barrier field-effect transistor (SBFET). The method may comprise providing a semiconductor substrate, forming a doped region in the semiconductor substrate, forming a gate electrode on the doped region, forming two electrodes in the semiconductor substrate aligned to and located at opposite sides of the doped region, at least one of the electrodes forming a Schottky contact or Schottky-like contact or rectifying contact with the doped region, the doped region being substantially uniformly doped in-between the two electrodes and at least along the depth of the at least one Schottky contact or Schottky-like contact or rectifying contact. The doping level is selected such that, in operation, the potential barrier of the at least one Schottky contact or Schottky-like contact or rectifying contact is reduced by an image-force mechanism.

According to most preferred embodiments of the invention, uniformly doping the semiconductor region may be performed up to a concentration of between 1 e16 $cm^{-3}$ and 1 e18 $cm^{-3}$. If the uniform channel doping concentration is too low, i.e. below 1e16 $cm^{-3}$, no substantial image force effect will occur. If the uniform channel doping concentration is too high, i.e. above 1e18 $cm^{-3}$, the effect of mobility degradation and even short-circuiting of the channel with the source/drain regions at higher channel doping levels will be dominant.

Uniformly doping the semiconductor region may be performed by implanting dopant elements.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

**Brief description of the drawings**

Fig. 1 shows a cross-section of a field effect transistor according to an embodiment of the present invention.
Fig. 2 shows a schematic process flow for the fabrication of a Schottky barrier field effect transistor according to an embodiment of the present invention.
Fig. 3 to Fig. 5 illustrate steps in a manufacturing process of a semiconductor device according to embodiments of the invention.
Fig. 6 shows dopant concentration in an ion-implanted part a silicon substrate according to an embodiment of the present invention.
Fig. 7 shows current voltage characteristics of PtSi/n-type junctions according to an embodiment of the present invention.

Fig. 8 shows the results of determination of Schottky barrier heights of the PtSi/n-type junctions shown in Fig. 7 taking the high series resistance into account.

Fig. 9 illustrates the mechanism of Schottky barrier height lowering by means of an image force effect according to an embodiment of the present invention.

Fig. 10 shows measured transfer characteristic at the source junction (Fig. 10 (a)) and at the drain junction (Fig. 10 (b)) of a Schottky barrier field effect transistor with a channel length of 1 $\mu$m for various substrate doping levels according to embodiments of the present invention.

Fig. 11 shows experimental and simulated transfer characteristics at the source junction of a Schottky barrier field effect transistor with a channel length of 1 $\mu$m for a higher ($N_D$ = 2e17 CM$^{-3}$) (Fig. 11 (a)) or lower ($N_D$ = 1e16 cm$^{-3}$) (Fig. 11 (b)) doped substrate according to an embodiment of the present invention.

Fig. 12 shows the simulated transfer characteristic at the source junction of a Schottky barrier field effect transistor with a channel length of 1 $\mu$m in case of a lower doped substrate ($N_D$ = 1e16 cm$^{-3}$) for various Schottky barrier heights according to embodiments of the present invention.

Fig. 13 shows the measured output characteristic at the source of a Schottky barrier field effect transistor with a channel length of 1 $\mu$m for various doping levels of the substrate according to an embodiment of the present invention.

Fig. 14 shows the measured transfer characteristic at the source of a Schottky barrier field effect transistor with a channel length of 1 $\mu$m for various doping levels of a substrate with fixed Schottky barrier according to an embodiment of the present invention.

Fig. 15 shows the simulated drive current at the source for a bulk p-type field effect transistor as a function of substrate doping level in case of semiconductor source/drain regions and in case of Schottky barrier source/drain regions without taking Schottky barrier lowering effect into account according to an embodiment of the present invention.

Fig. 16 shows a simulated transfer characteristic at the source for a bulk short channel (100 nm) p-type Schottky barrier field effect transistor for two different substrate doping levels according to embodiments of the present invention.

Fig. 17 shows the simulated transfer characteristic at the source for an SOI short channel (100 nm) p-type (Fig. 17 (a)) and n-type (Fig. 17 (b)) Schottky barrier field effect transistor for two different substrate doping levels according to embodiments of the invention.

In the different figures, the same reference signs refer to the same or analogous elements.


**Description of illustrative embodiments**

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects.

This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

The invention will now be described by a detailed description of several embodiments of the invention. It is clear that other embodiments of the invention can be configured according to the knowledge of persons skilled in the art without departing from the technical teaching of the invention, the invention being limited only by the terms of the appended claims.

Embodiments of the present invention provide a semiconductor device having first and second electrodes formed in a semiconductor substrate having a doping level, the first and second electrodes being separated from each other by a semiconductor region, and a third electrode for controlling conductivity of the semiconductor region, at least one of the first and second electrodes forming a rectifying contact with the semiconductor region, the rectifying contact having a potential barrier, wherein the semiconductor region is uniformly doped at least in a horizontal direction between the first and the second electrode, but preferably also in a vertical direction i.e. in a direction perpendicular to the third electrode, to have a doping level higher than the doping level of the semiconductor substrate and so as to, in operation, induce an image-force mechanism for lowering the at least one Schottky contact.

With horizontal direction is meant, when the semiconductor substrate is lying in a plane, in a direction substantially parallel to the plane of the substrate. With direction perpendicular to the third electrode is meant in a direction substantially perpendicular to the plane of the substrate.

An advantage of the semiconductor device according to embodiments of the invention is that it shows good short channel behaviour, good performance and high on-current.

The semiconductor device may be a p-type or an n-type device.

For the purpose of teaching embodiments of the invention, the invention will further be described by the semiconductor device being a p-type Schottky barrier field effect transistor (SBFET) having source and drain electrodes with a channel in between, and a gate electrode. However, the invention is not limited thereto. A person skilled in the art will realize that the teaching of embodiments of the invention is also applicable to n- type Schottky barrier field effect transistors as well.

Although embodiments of the invention are taught by means of a metal oxide semiconductor field effect transistor (MOSFET) embodiments of the invention may be applied to any type of transistor where the conductivity of a semiconductor region, e.g. channel, between two electrodes, e.g. first and second main electrode such as source and drain electrodes, can be modulated by means of a third electrode, e.g. a control electrode such as a gate electrode, and whereby at least one of these two electrodes, e.g. first and second main electrode such as source and drain electrodes, forms a Schottky contact, a Schottky-like contact or rectifying contact, also referred to as Schottky barrier, with the semiconductor region, e.g. channel. Examples may include, but are not limited to, CMOS, BICMOS, Bipolar and SiGe BICMOS. Examples of such transistors may, for example, be enhancement type FET, depletion type FET, junction FET (JFET), ....

According to embodiments of the invention, doping of this semiconductor region, e.g. channel, is performed and is selected to lower the Schottky barrier height of this Schottky-like contact by inducing an image-force mechanism (see further).

According to embodiments of the invention, at least one of the source and drain electrodes may be formed of a metal-semiconductor compound such as a silicide or a germanide. The present invention will further be described by means of a p-type Schottky barrier field effect transistor (SBFET) having source and/or drain regions comprising platinum silicide (PtSi). It is clear for a person skilled in the art that this is not limiting the invention in any way and that other metal-semiconductor-forming metals, e.g. silicide-forming metals, known in the art, such as, for example, refractory metals (e.g. Ni, Ti, Co) or lanthanides (e.g. Yb, Er, Pd) can also be used to form the source/drain regions. The choice of the metal-semiconductor-forming metals, e.g. silicide-forming material, will depend on the type of semiconductor device, e.g. transistor, to be formed (n-type or p-type) and on the Schottky barrier height to be obtained. Furthermore, the present invention also applies to semiconductor devices comprising source and drain electrodes of which at least one is formed of a different metal-semiconductor compound, such as for example a germanide or a germanosilicide.

For the purpose of teaching, embodiments of the present invention will be described by means of the use of phosphorous and/or arsenic for changing the doping level of the channel region. A person skilled in the art will realize that other n-type or p-type dopants, depending on the kind and type of semiconductor device to be formed, can be used such as, for example, In, B or As.

Embodiments of the present invention will further be described by means of a silicon substrate. A person skilled in the art will realize that various semiconductor substrates are available to which the teaching of the invention can be applied such as, for example, germanium (Ge) substrates, silicon-on-insulator (SOI) substrates, germanium-on-insulator (GOI) substrates, substrates with a channel region comprising silicon and/or germanium, substrates with strained channels.

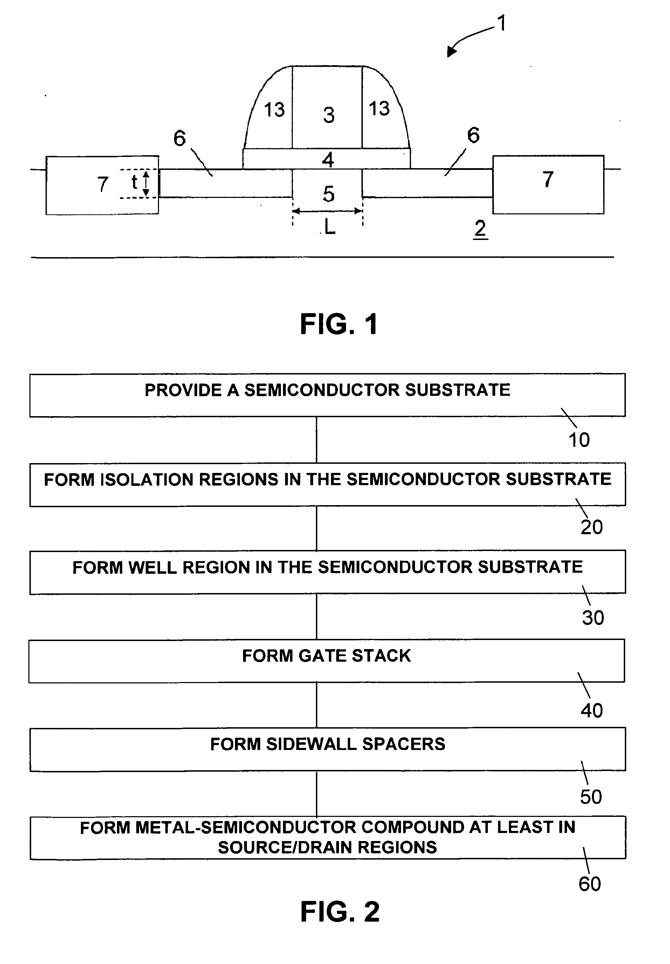

Fig. 1 shows a schematic lateral cross-section of a Schottky barrier field effect transistor (SBFET) 1 according to an embodiment of the present invention. The SBFET 1 comprises a conductive control electrode, e.g. gate electrode 3, electrically separated from a semiconductor substrate 2 by a control electrode dielectric, e.g. gate dielectric 4. Aligned to the gate electrode 3, first and second main electrodes, e.g. source/drain electrodes 6 are present. At least one of the source/drain electrodes 6 forms a Schottky contact or rectifying contact to a semiconductor channel 5 which is located in the substrate 2 and in-between both source/drain regions 6. The at least one Schottky contact may also be referred to as source/drain junction or as metal-semiconductor compound/ semiconductor junction, in particular for the example given a metal-silicide/semiconductor junction. Wherever in the description and claims is referred to Schottky contact, Schottky barrier, Schottky-like contact, Schottky diode, rectifying contact, source/drain junction, metal-semiconductor compound/semiconductor junction or metal-silicide/semiconductor junction, the same thing is meant, i.e. for the example discussed the metal or metal-silicide/semiconductor interface formed between the source/drain regions 6 and the channel 5. A rectifying contact is the metal-semiconductor contact which displays asymmetric current-voltage characteristics, i.e. it allows high current to flow across under a forward bias condition and it blocks current off under a reverse bias condition. This behaviour is controlled by bias voltage dependent changes of the potential barrier height in the contact region.

Optionally, sidewall spacers 13 may be present lying against the stack formed by the gate electrode 3 and the gate dielectric 4.

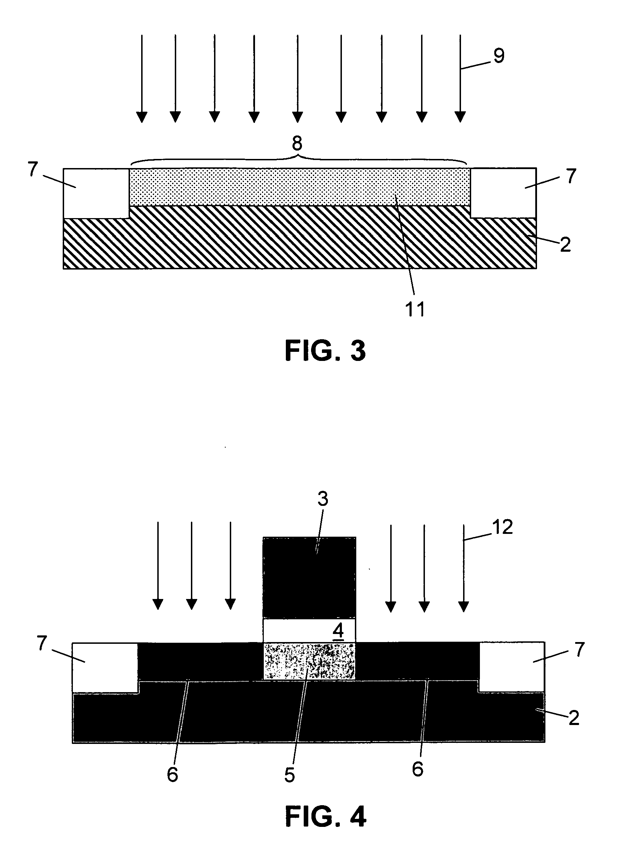

Fig. 2 schematically shows a flow chart of a fabrication process of a SBFET 1 according to a preferred embodiment of the present invention. This figure illustrates relevant process steps for a possible manufacturing sequence. Fig. 3 to 5 illustrate cross-sections of the SBFET 1 according to subsequent steps in the manufacturing process according to this preferred embodiment. It is to be understood that the illustrated manufacturing method is only an example and is not intended to limit the invention. For example, the method may comprise another sequence of process steps or may comprise more or less process steps. Furthermore, the method may also use other materials or processes.

The method according to embodiments of the invention may be used for manufacturing SBFETs in sub 32 nm CMOS technology, for example in sub 22 nm CMOS technology, i.e. technology where minimal length of devices is about 32 nm respectively 22 nm.

In a first step, an n-type (100) silicon substrate 2 is provided (step 10 in Fig. 2), preferably with a resistivity in the range of between 2.5 and 8.5 $\Omega$.cm. Typically, the substrate may be undoped, or may have a doping level of 5e15 $cm^{-3}$ in case of bulk substrates or 1e15 $cm^{-3}$ in case of SOI substrates. Isolation regions 7 are formed in the substrate 2 to provide a pattern of active regions 8 wherein the SBFETs 1 are to be formed (see Fig. 3; see step 20 in Fig. 2). The isolation regions 7 isolate neighbouring SBFETs 1 on the substrate 2. For the ease of explanation, the method will be described by means of only one SBFET 1. It has to be understood that this is not intended to limit the invention in any way. Any number of SBFETs 1, or in general any number of semiconductor devices 1, may be provided on a same substrate 2, depending on the application the semiconductor device 1, in the example given SBFET 1, is intended for. Preferably, the isolation regions 7 may be formed by shallow trench isolation (STI). STI isolation regions 7 may be formed by initially creating a shallow trench in the silicon substrate 2, e.g. by a conventional photolithographic and anisotropic dry etch process such as a reactive ion etching (RIE) procedure, using e.g. $Cl_2$ as an etchant. The shallow trench is created to a depth of for example between about 200 to 600 nm in the silicon substrate 2. After removal of the photoresist pattern, used for shallow trench definition, by plasma oxygen ashing and careful wet cleans, a silicon oxide layer is deposited, for example by a low pressure chemical vapour deposition (LPCVD) procedure or by a plasma enhanced chemical vapour deposition (PECVD) procedure, to a thickness between about 300 to 1500 nm. The shallow trenches are thus completely filled. Removal of the silicon oxide from regions other than inside the shallow trenches is accomplished using either a chemical mechanical polishing (CMP) procedure, or via a RIE procedure using a suitable etchant, resulting in insulator filled STI regions 7.

Instead of STI, the isolation regions 7 may also comprise LOCOS (local oxidation of silicon) regions. These LOCOS regions 7 may be formed via initially forming an oxidation resistant mask, such as silicon nitride, then exposing regions of the semiconductor substrate not protected by the silicon nitride masking pattern, to a thermal oxidation procedure. LOCOS regions 7 are thus created at a thickness equal to the depth of STI regions 7. After formation of the LOCOS regions 7, the oxidation resistant mask is removed.

In a next step, the active regions 8 of the substrate 2 are doped, e.g. implanted with dopant elements (indicated with arrows 9 in Fig. 3) to form a well region 11 in the substrate 2 (step 30 in Fig. 2; Fig. 3). The kind of dopant elements used depends on the type of semiconductor device 1, in the example given SBFET 1, to be formed. For example, for p-type devices 1 preferably dopant elements selected from group V elements may be used, such as e.g. P and/or As. For n-type devices 1 preferably one or more dopant elements selected from group III elements may be used, such as e.g. In and/or B. Doping may be performed by any suitable technique known by a person skilled in the art, such as, for example, by ion implantation or by plasma doping. According to the present invention, doping of the channel 5 is performed such that an image-force mechanism is induced (see further) which lowers the potential barrier of the Schottky contact between at least one of the source/drain electrodes 6 and the channel 5, also referred to as Schottky barrier.

In a next step, a dielectric layer, which will later on serve as gate dielectric 4, may be deposited onto the substrate 2 followed by deposition of a conductive layer, e.g. boron-doped polycrystalline silicon layer, which will be used to form gate electrode 3. The dielectric layer may comprise a single dielectric layer, such as a semiconductor oxide or oxynitride, e.g. $SiO_2$, SiON, a high-k dielectric such a hafnium silicate or hafnium oxide, or a stack of dielectric layers, such as a high-k dielectric and a semiconductor oxide, e.g. $HfSiO_2/SiO_2$. The conductive layer may, for example, comprise a metal such as TiN or TaN or may comprise any other suitable conductive material. The dielectric layer and the conductive layer form a stack. The stack of the dielectric layer and the conductive layer may then be patterned, e.g. lithographically patterned, to form a gate stack 3, 4 of the SBFET 1 (step 40 in Fig. 2; see Fig. 4). It has to be noted that, according to the example given in Fig. 4, the dielectric layer and the conductive layer are patterned in one step to form a gate stack 3, 4 comprising a gate dielectric 4 and gate electrode 3 having a same width. However, according to other embodiments of the invention, the dielectric layer and the conductive layer may be separately patterned so as to form a gate dielectric 4 and a gate electrode 3 having a different width, as can be seen in Fig. 1.

In a next step, source/drain regions 6 of the SBFET 1 are formed by doping, e.g. by implanting dopant elements as indicated by arrows 12 in Fig. 4. Optionally, sidewall spacers 13 may be formed against the gate stack 3, 4 by, for example, anisotropically etching back a thin dielectric layer, e.g. silicon nitride layer, which is uniformly deposited over the substrate 2 (step 50 in Fig. 2). Then, a metal layer, e.g. a platinum layer, is deposited over the substrate 2, followed by a silicidation step to silicidise the source/drain regions 6 so as to form source/drain electrodes 6. Preferably, silicidation of the source/drain regions 6 is performed by performing a rapid thermal anneal step (RTP) at about 550°C. After annealing, unreacted metal, e.g. platinum, may be removed, for example by a selective etch using a wet etchant such as aqua regia. According to embodiments of the invention, during silicidation of the source/drain regions 6, also the gate electrode 3 may be silicided. Alternatively only the source/drain regions 6 may be silicided to form source/drain electrodes 6, while the gate electrode 3 is not silicided. Therefore, in this case, before deposition of the metal layer, e.g. platinum layer, a mask may be provided onto the gate electrode 3 (not illustrated). According to still other embodiments, the source/drain regions 6 and the gate electrode 3 may be silicided in different steps and with different silicide-forming metals. Again, in this case, a mask may be provided onto the gate electrode 3 before depositing the first silicide-forming metal layer, e.g. platinum layer. After silicidation of the source/drain regions 6, a mask may be provided on these regions 6 before a layer of a second silicide-forming metal is provided for silicidation of the gate electrode 3. Due to lateral diffusion of the formed silicide, e.g. PtSi, under the spacers 11 during the silicidation step, the source/drain electrodes 6 formed are substantially aligned to the gate stack 3, 4.

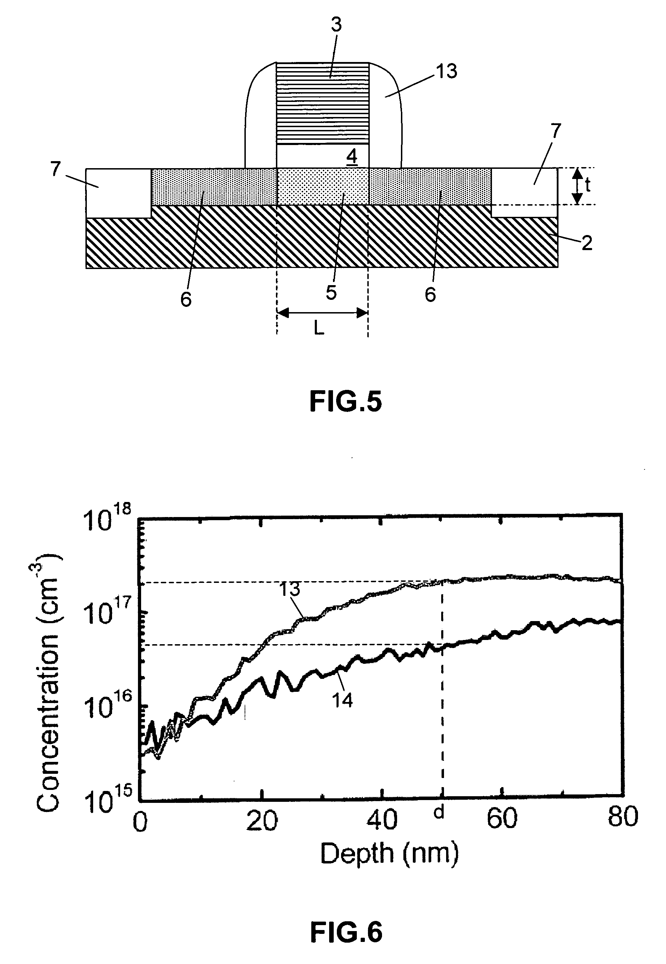

The resulting SBFET 1, formed using the method according to the present embodiment, may comprise source/ drain electrodes 6 with a thickness t of, for e.g. sub 32 nm or sub 22 nm CMOS technology, less than 200 nm, preferably less than 150 nm (see Fig. 5).

The method according to embodiments of the invention leads to a SBFET 1 with source/drain electrodes 6, in the example given, PtSi/n-Si junctions which behave as Schottky barriers or, in other words, form Schottky diodes. This means that electrons coming from a source/drain electrode 6 and going to the channel 5, experience a potential barrier which they have to overcome before they can flow to the channel 5. By first providing the active regions 8, part of which will form the channel 5 of the device 1, with additional dopants in a concentration of between 1e16 cm$^{-3}$ and 1e18 cm$^{-3}$ the Schottky barrier may be lower than when no additional doping is performed. This will further be described and illustrated hereinafter.

According to embodiments of the present invention, the doping level of the channel 5 is increased although it would be expected that the mobility of charge carriers will hereby be degraded. However, it has been found by the present inventors that this mobility degradation is compensated for more than expected by the decrease in barrier height such that the drive current remains high and is thus not substantially influenced by increasing the doping level. The shift in threshold voltage $V_t$ due to the increased channel doping can be controlled by an appropriate choice of material for forming the gate electrode, in particular the choice of workfunction of that material. The contribution of the increased channel doping to the threshold voltage $V_t$ may then be compensated for by a decreased workfunction of the gate electrode.

Where in the further description and claims is referred to additional doping it is meant that a doping step is performed for intentionally doping or controlling dopant concentration in the channel 5 of the SBFET 1.

In the examples and the discussion hereinafter both hole barrier heights and electron barrier heights will be discussed. Both these barriers are relevant in both p-type and n-type devices. The barrier related to minority carriers of a channel 5 controls the drive current, also referred to as on-current, while the barrier related to majority carriers of a channel 5 controls the leakage current, also referred to as off-current. In case of, for example, a p-type device, electrons create leakage current in the channel 5, while holes create drive current in the channel 5.

Hereinafter, a comparative example will be described illustrating the method according to embodiments of the invention. This example will compare Schottky contacts formed between source/drain electrodes 6 and the channel 5 of SBFETs 1 formed on substrates which are additionally doped according to the present invention and of SBFETs 1 formed on substrates which are not additionally doped. This example will illustrate the advantageous effect of the method according to the present invention.

For the purpose of this example, a silicon substrate 2 was divided into two parts, a first part and a second part, also respectively referred to as south well and north well. Dividing the substrate 2 into two parts is only for the ease of comparison. The first part or south well of the substrate 2 is then additionally doped with dopant elements to form a well region 11 in the substrate 2, part of which will later form the channel 5 of the SBFET 1. For this comparative example, according to first experiments P (3e12 cm$^{-2}$, I20 KeV) and according to second experiments a combination of P (3e12 cm$^{-2}$, 120 KeV) and As (1e12 cm$^{-2}$, 90 keV) was used (see further) to dope the active regions 8. The second part or north well of the substrate 2 was not doped before the SBFET 1 was formed on it.

SBFETs 1 were then formed on both the first and second part of the substrate 1 as described above.

Fig. 6 shows a simulated dopant element profile of the channel 5 of the SBFET 1 formed on the first part of the substrate 2 for the two different doping conditions, i.e. for P (curve 13) and for P/As (curve 14). In this figure the concentration of the dopant elements, defined by the number of dopant elements per cm$^3$, is given as a function of the depth into the substrate 2. This depth is measured from the surface of the substrate 2 on which the SBFET 1 is formed, or in other words from which the substrate 2 is doped (0 nm) towards the bulk of the substrate 2. In Fig. 6 also the vertical location, i.e. the depth d in the substrate 2, of the metal-semiconductor compound/semiconductor interface, in the example given the PtSi/n-Si interface, is indicated (vertical dashed line in Fig. 6). It can be seen that, according to the present example, the PtSi/n-Si interface is located at a depth d of about 50 nm from the gate dielectric 4 or substrate surface. At this depth d the concentration is about 2e17 cm$^{-3}$ for the P/As doped substrates 2 and about 5e16 cm$^{-3}$ for the P doped substrates 2. Capacitance-voltage measurements on the SBFET devices 1 formed indicate a doping level of 1e16 cm$^{-3}$ in the second part or north well (which was not additionally doped before formation of the SBFET 1) and of 8e16 cm$^{-3}$ or 2e17 cm$^{-3}$ in the first part or south well (which was doped respectively with P or with P/AS before formation of the SBFET). The electrical equivalent oxide thickness (EOT) of the SiON gate dielectric 4 extracted from these capacitance voltage curves is determined at about 2 nm. The lateral width of the SiN spacers 5 is about 11 nm. This may, for example, be determined by Scanning Electron Microscopy (SEM).

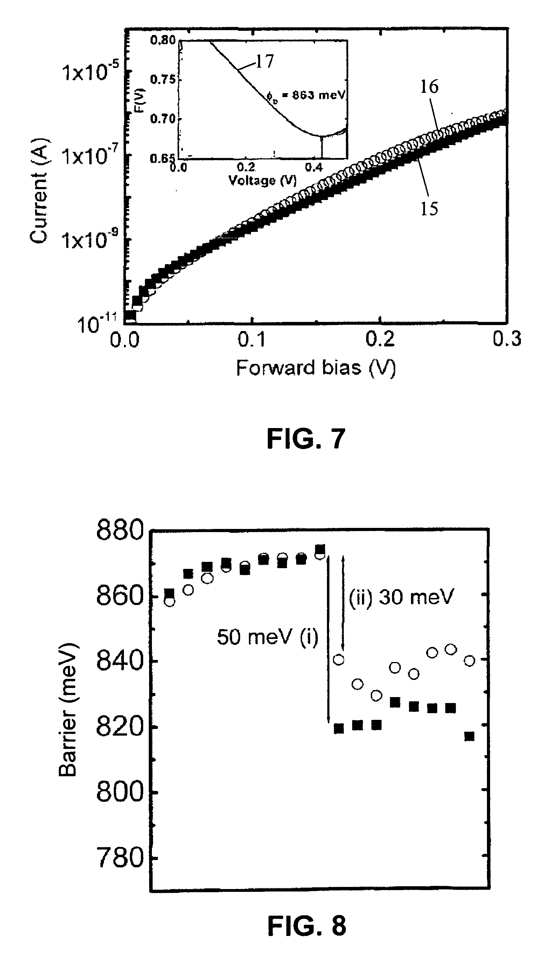

When forward biasing the metal-semiconductor compound/semiconductor junction, e.g. silicide-semiconductor junction, in the example given the PtSi/n-Si junction, formed, the height of the potential barrier formed also referred to as Schottky barrier height, can be determined from the current flowing through the junction during biasing. Fig. 7 shows typical current voltage curves measured on two PtSi/n-Si diodes of 100 μm x 100 μm in substrates 1 with different dopant concentration, i.e. for a first part or south well (additionally doped) having a dopant concentration of 2e17 cm$^{-3}$ (curve 16) and for a second part or north well (not additionally doped) having a dopant concentration of 1e16 cm$^{-3}$ (curve 15). According to the present experiment, for the ease of performing the experiment, a Schottky contact is formed on a first main surface. A metal contact is formed on a second main surface opposite to the first main surface. This metal contact serves as a contact location for a probe for measuring the Schottky barrier. Hence, the Schottky barrier is measured through the substrate and thus there is a long current path, which may lead to high parasitic series resistance. Considering the possibly high parasitic series resistance of the Schottky contacts and taking into account the series resistance of the probe , a method initially provided by Norde et al. in, "A modified forward I-V plot for Schottky diodes with high series resistance", J. Appl. Phys., 50 (7), pp. 5052-5053, 1979, is adapted by using the minimum of this NORDE function. The electron Schottky barrier height ($\phi_e$) of the PtSi/n-Si interface is determined using a minimum value ($V_{min}$) of the Norde function F(V) as known by a person skilled in the art.

$$F(V) = \frac{V}{2} - \frac{kT}{q} \ln\left(\frac{1}{AA^{**}T^2}\right) \Rightarrow \phi_e = F(V_{min}) + \frac{V_{min}}{2} - \frac{kT}{q} \qquad (1)$$

wherein A$^{**}$ is the Richardson's constant for the semiconductor, A the Schottky diode area, T the temperature, k the Boltzmann constant, V the forward bias and q an electronic charge.

The Norde function F(V) is plotted for the second part or north well (not additionally doped, curve 17) in the inset of Fig. 7. This plot is then used to determine the Schottky barrier height for the PtSi/n-Si interface.

A set of electron Schottky barrier heights of PtSi/n-Si source/drain junctions determined as described above is plotted in Fig. 8. Schottky barrier junctions were measured in a statistical manner, i.e. measurements were performed along a straight line on the substrate 2, for both the first and second part of the substrate 2. From the left part of Fig. 8 it can be seen that the electron barrier height or Schottky barrier height (SBH) of the north well diodes (second part of the substrate 2, not additionally doped) is almost constant along the line of measurement and has an average value close to 870 meV. In the south well (first part of the substrate 2, additionally doped), the values of the SBH are a function of the dopant concentration. The average value of the SBH is around 840 meV for the 8e16 cm$^{-3}$ doped substrate (only P-doped) and 820 meV when the doping concentration is 2e17 cm$^{-3}$ (P/As doped) (see right part of Fig. 8). The fluctuation on the Schottky barrier height determined for the south well junctions (first part of the substrate 2, additionally doped) can be due to variations of the thickness t of PtSi (see Fig. 5) in the non-doped substrate. These barrier fluctuations can be reduced or minimized by improving the uniformity of the substrate doping, for example by increasing the doping level or by using plasma doping instead of ion implantation, at least in the channel region close to the silicide-semiconductor junction, and/or by reducing the variation of thickness t of the silicide regions 6. The latter is related to control of process technology and may be performed by e.g. control of the thickness of the layer of metal-semiconductor compound forming metal, e.g. silicide forming metal, during deposition (e.g. by plasma vapour deposition (PVD)), treatment of surface (cleaning, pre-amorphization), thermal budget controlling diffusion of silicide-forming species, ....

It can be seen from Fig. 8 that the difference in barrier height between PtSi/n-Si junctions formed in the first part of the substrate 2 (additionally doped) and junctions formed in the second part of the substrate 2 (not additionally doped) increases when the dopant concentration is increased. The Schottky barrier height is reduced by about 30 meV when the dopant level is 8e16 cm$^{-3}$ in the first part and 1e16 cm$^{-3}$ in the second part of the substrate 2 (open circles in Fig. 8) while the Schottky barrier height is reduced by about 50 meV when the dopant level is 2e17 cm$^{-3}$ in the first part and 1e16 cm$^{-3}$ in the second part of the substrate 2 (filled squares in Fig. 8).

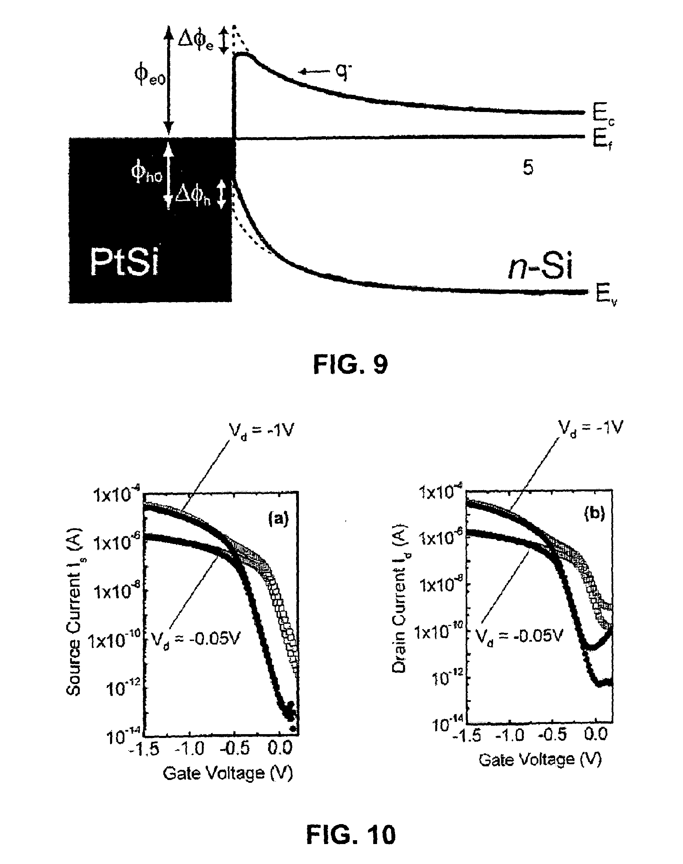

Hence, from the above experiment it can be seen that, because of the additional doping of the channel region of the SBFET 1, the potential barrier height of the formed Schottky contacts between at least one of the source/drain electrodes 6 and the channel 5 is lowered. Lowering of the barrier height because of this additional doping may be caused by the induction of an electrostatic force, also referred to as image-force and known by a person skilled in the art. This image-force attracts charge carriers to the metal-semiconductor compound, e.g. metal-silicide, thereby decreasing the electric field which repels the carrier from the metal-semiconductor compoundsemiconductor interface. When an electron is to be transported over a Schottky barrier, it may experience a lowering of that potential barrier height caused by its electric field. This is called image-force effect or Schottky effect. As sketched in Fig. 9, the presence of an image-force resulting from the appropriate selection of a uniform channel doping according to embodiments of the present invention, would result in a reduction ($\Delta\Phi$) of the effective electron ($\phi_{e0}$) and hole ($\phi_{h0}$) Schottky barrier height. This is because the additional doping $N_D$ determines the maximum electrical field $E_{max}$ in the channel 5:

$$E_{max} = \sqrt{\frac{qN_D 2(\phi_i - V_a)}{\varepsilon_s}} \qquad (2)$$

wherein ND is the dopant concentration, $\phi_i$ the built-in potential, $V_a$ the applied voltage and $\varepsilon_s$ the permittivity of the semiconductor.

The reduction of the Schottky barrier ($\Delta\Phi$) may then be given by:

$$\Delta\Phi = \sqrt{\frac{qE_{max}}{4\pi\varepsilon_s}} \qquad (3)$$

On the left of Fig. 9 the potential energy band diagram of the source/drain electrode 6, i.e. PtSi, is given, while on the right the potential energy band diagram of the doped n-type semiconductor channel 5, in the example given n-Si channel 5, is given for the situation of thermal equilibrium. When an electron from the n-Si channel 5 approaches the PtSi/n-Si interface, it will exert an electrostatic force on the charges (free electrons) in the PtSi. In that way, a 'hole', or more correctly a locally decreased electron concentration, may be induced by the repulsing force of the electron from the n-Si channel 5. This 'hole' forms the mirror image of the electron in the n-Si channel 5 and will exert a force. By this force, the electron will have a negative potential energy with respect to an electron at infinite distance. This potential energy caused by the mirror image must be added to the potential energy of the Schottky barrier. The result of this phenomenon is a lowering of the potential barrier height.

As can be seen in figure 6 it is the barrier height itself that is being reduced, while the band bending in the semiconductor region 5 remains substantially unaffected. As the barrier height itself is reduced thermo-ionic emission of carriers from the metal-semiconductor compound region, e.g; silicide region 6, to the channel 5 over the barrier is more likely to occur at a given temperature. Although this barrier height reduction is small compared to the barrier height itself, this reduction is of interest as it depends on the voltage applied over the silicide-semiconductor interface resulting in a voltage dependent reverse bias current. Preferably, the absolute value of the barrier may be below 200 meV. In other words, the drive current of the field effect transistor in the on-state will progressively increase with increasing drain-to-channel voltage.

The Schottky barrier lowering

$$( \Delta\phi = 2\sqrt{qE/16\pi\varepsilon_s}$$

with $\varepsilon_s$ being the permittivity of the semiconductor or channel region 5) can be calculated for example from a simulation in MEDIC1 (TCAD software from Synopsys) of the electric field E at the PtSi/n-Si interface, for a relatively low forward bias voltage of e.g. 50 mV. The data obtained by this simulation are summarized in Table 1 below. It is seen that the simulations are in good agreement with the measurement data obtained and described above. The electric field E increases with the forward bias voltage applied over the Schottky barrier junction and thus the effective Schottky barrier lowering, which is calculated for a relatively low voltage of 50 mV in Table 1, will be even more enhanced when the device is in the on-state. With increasing bias voltage applied to the source/drain regions 6, the Schottky barrier height will even further decrease resulting in a further improvement of the transistor current when the transistor is in the on-state.

TABLE 1

| Simulation of SBH lowering by image-force | | | | |
|---|---|---|---|---|
| Doping (cm$^{-3}$) | E at interface (V/cm) | e-SBH lowering by image-force | e-SBH difference | |
| | | | calculated | measured |
| 1016 | 2e4 | 15.7 meV | - | - |
| 8e16 | 1 e5 | 39.3 meV | ~ 25 meV | 30 meV |
| 2e17 | 3e5 | 60.9 meV | ~ 45 meV | 50 meV |

Table 1: Simulated maximum electric field at the metallic-semiconductor junction, Schottky barrier height lowering calculated using formula (I), and the Schottky barrier height difference calculated and measured for doping level 8e16 cm$^{-3}$ and 2e17 cm$^{-3}$ with respect to the Schottky barrier height for the 1e16 cm$^{-3}$ doped substrate

The lowering ($\Delta\Phi$) of the Schottky barrier height for holes ($\phi_{h0}$) due to the image-force mechanism, as illustrated in Fig. 9, directly impacts on the performance of p-type SBFETs 1. This is because in p-type devices holes are determining the drive current, also referred to as on-current. If the barrier is lowered, the "on-resistance" due to the barrier is also lowered. The source current $I_s$ versus gate voltage $V_g$ curve and the drain current $I_d$ versus gate voltage $V_g$ curve of p-type SBFETs 1 formed in the second part of the substrate 2 or north well (1e16 cm$^{-3}$, open squares, not additionally doped) and the first part of the substrate 2 or south well (additionally doped, 2e17 cm$^{-3}$, filled circles) are represented in Fig. 10(a) and 10(b) respectively. These curves are measured on 1 $\mu$m channel length SBFETs 1 at a drain voltage $V_d$ of -0.05 V (lower curves) or -1 V (upper curves). Due to drain junction leakage induced by electron tunnelling, the current through the drain junction when the SBFET 1 is in the off-state (gate voltage = 0 V) is much larger than the current through the source junction when in the off-state (gate voltage = 0 V). This junction leakage could be reduced to a great extent by using a silicon-on-insulator (SOI) substrate 2 for manufacturing the SBFETs 1 as substantially no leakage current will flow through the silicide region 6 in contact with the insulating layer of the SOI substrate towards the SOI substrate 2. For the purpose of teaching the invention, only the $I_s$-$V_g$ transfer characteristic is analysed, although similar observations can be made for the $I_d$-$V_g$ transfer characteristic. The sub-threshold slope S of the $I_s$-$V_g$ transfer characteristic of the SBFETs 1 in the first part of the substrate 2 or south well (additional doping, solid circles) is about 70 mV/dec, with a ratio $I_{on}/I_{off}$ between the transistor current in the on-state $I_{on}$ and the transistor current in the off sate $I_{off}$ of about 10$^7$. This illustrates good electrical properties of PtSi source/drain SBFETs 1 fabricated according to embodiments of the invention. It can be seen that the threshold voltage $V_t$ is about -0.5V. In the sub-threshold region at the

right side of $V_t$, it can be seen that the curve shows a single sub-threshold slope. The steeper the sub-threshold slope is, the less voltage is required to make a transition from the off- to the on-state.

The increased channel doping not only provides a lower Schottky barrier height and a steep single sub-threshold slope, but also a substantial reduction of the drain-induced-barrier-lowering effect (DIBL) which in its turn reduces the leakage current of the transistor. When increasing the channel doping from 1e16 cm$^{-3}$ to 2e17 cm$^{-3}$ the DIBL value is reduced from about 40 mVN to about 5 mVN. This can be determined by measuring two $I_d$ vs $V_g$ curves with different $V_d$, e.g. $V_d$ = 50mV and $V_d$ = 100mV and then determining the threshold voltage $V_t$ for each $V_d$ from these curves. The DIBL can then be determined by:

$$DIBL = \frac{V_t(V_d = 50mV) - V_t(V_d = 100mV))}{100mV - 50mV} \qquad (4)$$

Most likely this DIBL reduction is due to the reduction of the depletion region in the highly doped channel region 5.

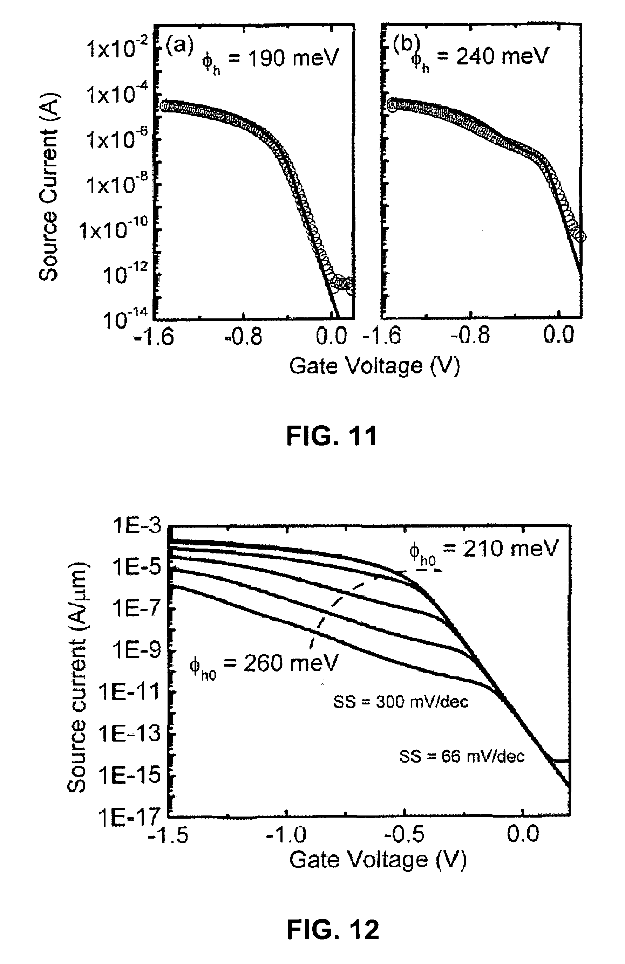

Fig. 11 (a) and 11 (b) show simulated (solid line) and measured (open circles) $I_s$-$V_g$ transfer characteristics of the SBFETs 1 for a substrate doping $N_D$ of 2e7 cm$^{-3}$ (Fig. 11 (a)) and of 1e16 cm$^{-3}$ (Fig. 11(b))). The $I_s$-$V_g$ transfer characteristics are measured with a drain voltage of -1.1 V. Curves simulated with MEDIC1 simulation software of SYNOPSIS and measured transfer curves are, as shown in Fig. 11 (a) and 11 (b), in good agreement. The difference in Schottky barrier height between lower (Fig. 11 (b)) and higher (Fig. 11 (a)) doped channel regions used to simulate the transfer characteristic $I_s$-$V_g$ is again in good agreement with the 50 meV difference observed in the Schottky barrier height determined from the diode characteristic shown in Fig. 7 and table 1. In the $I_s$-$V_g$ transfer characteristic of the SBFETs 1 in the second part of the substrate 2 or north well (Fig. 11(b)), lower doped) two different values for the sub-threshold slope S are measured, while there is only one value measured for the sub-threshold slope S for the SBFETs 1 in the higher doped second part of the substrate 2 or south well (Fig. 11 (a)). From simulation results shown in Fig. 12, it is observed that due to the high Schottky barrier height there is a variation of the sub-threshold slope S at the transition from the sub-threshold thermo-ionic emission to the field emission regime. This is because different physical effects are playing a role. For low barriers, normal sub-threshold behaviour may be observed, i.e. charge carriers can pass the low barrier thanks to thermal energy (thermionic emission) as is also the case for normal source/channel semiconductor junctions which form no Schottky barrier junctions. Fig. 12 illustrates that the hole barrier should be 200 meV or lower to hide the effect of the barrier, i.e. for the source/channel and/or drain/channel junctions to behave as normal source/channel and/or drain/channel junctions. As can be seen from the figure, for a barrier height of 210 meV a single sub-threshold slope SS of 66 mV/dec is present in the curve for obtaining a drive current of about 1e-5 A/$\mu$m. When the barrier increases toward 260 meV, a dual sub-threshold slope (SS = 66 mV/dec and SS = 300 mV/dec) is present in the curve before a current only of between 1e-7 A/$\mu$m and 1 e-5 A/$\mu$m is obtained. This is because, when the barrier gets higher, electrical field becomes more important. However, as the Schottky barrier height is lowered by increasing the uniform doping of the channel region 5, the transfer curve $I_s$-$V_g$ is characterised by a single sub-threshold slope S due to sub-threshold thermo-ionic emission. Fig. 12 shows a simulated transfer characteristic for a 1 $\mu$m channel length SBFET 1 with a channel doping of 1e16 cm$^{-3}$ and a drain voltage of -1.1 V while the source is biased to 0 V. For this simulation the hole barrier height which determines the drive current, also referred to as on-current, of the p-type SBFET 1 is used as a parameter to simulate the drive current vs gate voltage. Therefore, the effective hole Schottky barrier height is varied from 260 meV to 210 meV.).

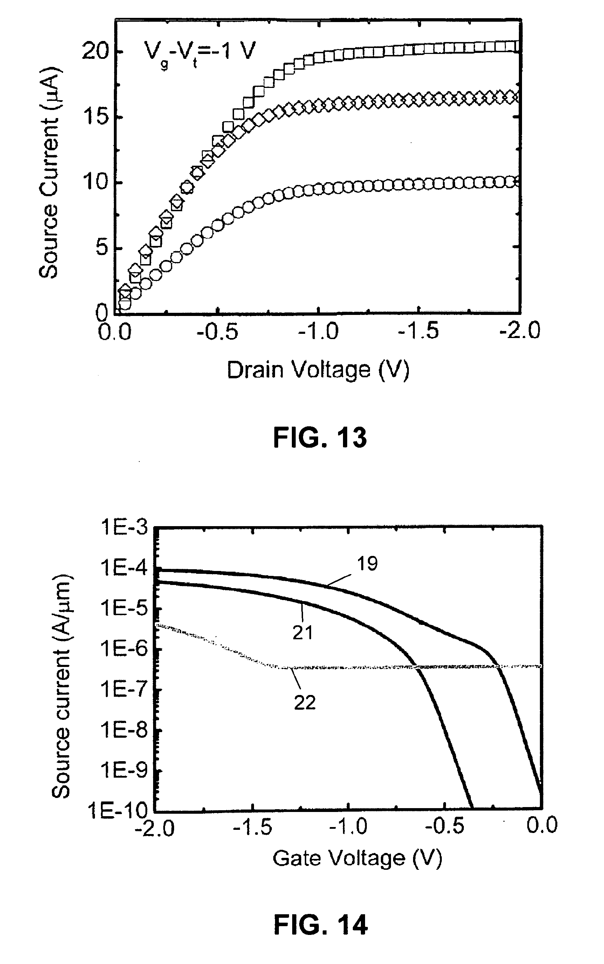

Fig. 13 shows a measured output curve, i.e. source current $I_s$ versus drain voltage $V_d$ for SBFETs 1 with a channel length of 1 $\mu$m with a $V_g$-$V_t$ = -1V with $V_t$ being the threshold voltage of the SBFET 1 for the three different substrate doping levels as described above, i.e. 1e16 cm$^{-3}$ (open circles), 8e16 cm$^{-3}$ (open diamonds) and 2e17 cm$^{-3}$ (open squares). With increased channel doping the drive current is increased thanks to the Schottky barrier lowering effect. Although it would be expected that the reduction of the hole mobility due to higher substrate doping levels would lower the drive current $I_s$, the overall effect of increased substrate doping $N_D$ is observed to be an increased drive current through image-force barrier lowering effect.

Fig. 14 shows a measured transfer curve, i.e. source current $I_s$ versus gate voltage $V_g$, for SBFETs 1 with a channel length of 1 $\mu$m with a drain voltage of -1.1 V for three different substrate doping levels, i.e. 1e16 cm$^{-3}$ (curve 19), 1e18 cm$^{-3}$ (curve 21) and 1e19 cm$^{-3}$ (curve 22). For reason of comparison the Schottky barrier height is simulated to be the same for the three doping levels. If the uniform channel doping concentration is too low, i.e. below 1e16 cm$^{-3}$, no substantial image force effect will occur. If the uniform channel doping concentration is too high, i.e. above 1e18 cm$^{-3}$, the effect of mobility degradation and even short-circuiting of the channel 5 with the source/drain regions 6 at higher channel doping levels will be dominant.

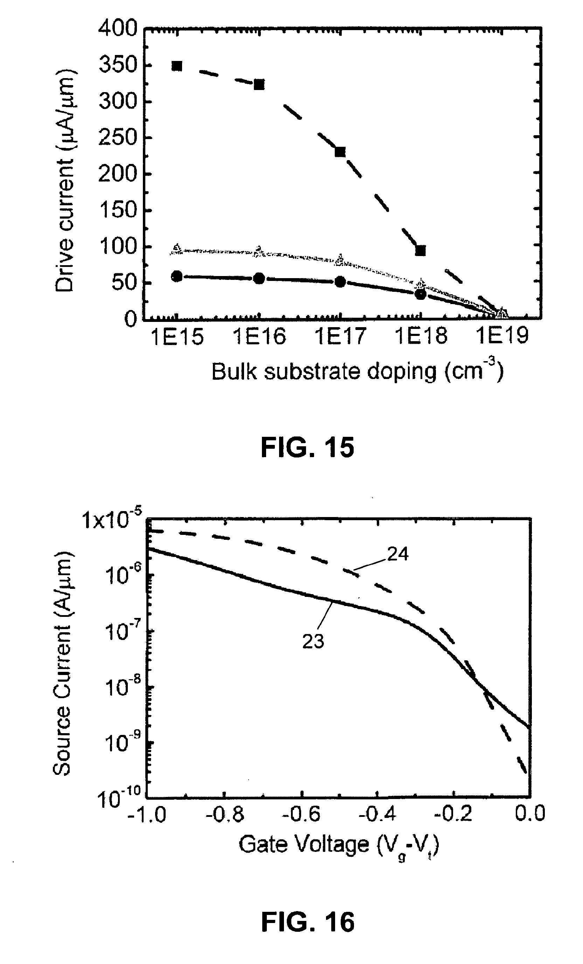

Fig. 15 shows a simulated drive current $I_s$ as a function of the substantial uniform channel doping for a field effect transistor with conventional doped source/drain regions 6 (filled squares) and with Schottky barrier source/drain regions 6 for a barrier height of 190 meV (filled triangles) or 250 meV (filled circles). Schottky barrier lowering effect according to the present invention was hereby taken into account. The drive current was simulated with gate voltage of $V_g$-$V_t$ = -2 V, a drain voltage of -1.1 V, a source voltage of 0 V and a bulk voltage of 0 V. The absolute values of these curves are not relevant as the Schottky barrier lowering due to the image-field effect was not taking into account. However from these curves, in particular the decrease of the drive current with increasing doping level, it can be concluded that a conventional field effect transistor is more prone to mobility degradation than Schottky barrier field effect transistors. For the latter devices the drive current remains almost independent from the dopant level in the region from about 1e16 cm$^{-3}$ to about 1e18 cm$^{-3}$.

The substrate or channel doping concentrations also influence the performance of short channel SBFET 1. The simulated transfer characteristic $I_s$-$V_g$ of two bulk SBFETs having a gate length L of 100 nm and a substrate doping $N_D$ of respectively 1e16 cm$^{-3}$ (solid line, curve 23) and 1e18 cm$^{-3}$ (dashed line, curve 24) is shown in Fig. 16. Taking into account the Schottky barrier lowering effect and the difference in threshold voltage due to the different channel doping, a higher drive current is obtained for the higher-doped SBFET 1.

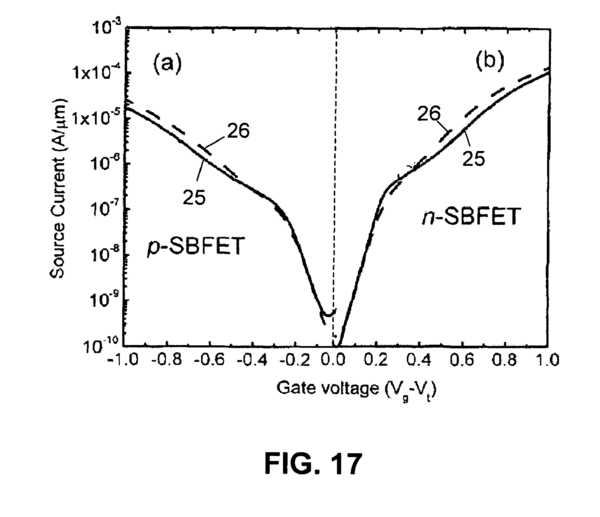

Fig. 17 shows a simulated transfer characteristic $I_s$-$V_g$ for p-type (Fig. 17(a)) and for n-type (Fig. 17(b)) SBFETs 1 manufactured on an SOI substrate 2 with a silicon body thickness of I0 nm and a silicide thickness of about 4 nm. Whereas, in the example given, PtSi was used to form the metallic source/drain regions 6 for the p-type SBFET 1, YbSi may be used to form source/drain regions 6 for an n-type SBFET 1. The SBFETs 1 have a gate length L of 100 nm and a substrate doping $N_D$ of respectively 1e16 cm$^{-3}$ (solid line, curve 25) and 1e18 cm$^{-3}$ (dashed line, curve 26). Taking into account the Schottky barrier lowering effect and the difference in threshold voltage due to the different channel doping, again a higher drive current is obtained for the higher-doped SBFET 1.

The present application thus demonstrates, in one of its embodiments, that the Schottky barrier height for holes in PtSi/n-Si junctions can be lowered by increasing the n-Si channel doping to an appropriate dopant level resulting in an image-force mechanism. Because of the lowering of the Schottky barrier height a substantial gain of the drive current in long-channel bulk p-type SBFETs may be obtained. A channel dopant concentration of 2e17 cm$^{-3}$ obtained by the combined ion implantation of P (3e12 cm$^{-2}$, I20 KeV) and As (1e12 cm$^{-2}$, 90KeV) can be used to lower the hole Schottky barrier height by more than 50 meV, while the drive current of the corresponding 1 $\mu$m channel length SBFET 1 is increased by a factor of 2.

Similarly, the method according to embodiments of the invention, the method according to embodiments of the invention may be used to lower the electron Schottky barrier height for n-type semiconductor devices 1.

Moreover, numerical simulations show that this channel doping is also critical for improving the performance of short-channel n-type and p-type SBFETs 1 manufactured on bulk semiconductor substrates 2 or on silicon-on-insulator (SOI) substrates.

The disclosed method of modulating the Schottky barrier height by means of an image force lowering effect can be easily implemented in state-of-the-art semiconductor manufacturing processes as it relies on the conventional CMOS process techniques such as ion implantation to adjust the dopant of the substrate to an appropriate level, which is substantially uniform over the channel both in lateral and in vertical direction.

It is to be understood that although preferred embodiments, specific constructions and configurations, as well as materials, have been discussed herein for devices according to the present invention, various changes or modifications in form and detail may be made without departing from the scope of this invention as defined by the appended claims.

**Claims**

1. A semiconductor device (1) having first and second electrodes (6) formed in a semiconductor substrate (2) having a doping level, the first and second electrodes (6) being separated from each other by a semiconductor region (5), and a third electrode (3) for controlling conductivity of the semiconductor region (5), at least one of the first and second electrodes (6) forming a rectifying contact with the semiconductor region (5), the rectifying contact having a potential barrier,
wherein the semiconductor region (5) is uniformly doped, at least in a direction between the first and the second electrodes, to have a doping level higher than the doping level of the semiconductor substrate (2) and so as to, in operation, induce an image-force mechanism for lowering the potential barrier of the at least one rectifying contact.

2. A semiconductor device (1) according to claim 1, wherein the doping level of the semiconductor region (5) is between 1e16 cm$^{-3}$ and 1e18 cm$^{-3}$.

3. A semiconductor device (1) according to claim 1 or 2, the semiconductor region (5) having a length and the rectifying contact having a depth into the semiconductor substrate (2), wherein the semiconductor region (5) is uniformly doped along its length and at least along the depth of the rectifying contact.

**4.** A semiconductor device (1) according to any of the previous claims, wherein the first and second electrode (6) comprise a metal-semiconductor compound.

**5.** A semiconductor device (1) according to any of the previous claims, wherein the semiconductor device (1) is a p-type semiconductor device.

**6.** A semiconductor device (1) according to claim 5, wherein the first and second electrode (6) comprise platinum silicide.

**7.** A semiconductor device (1) according to claim 5 or 6, wherein the semiconductor region (5) is uniformly doped with one or more dopant elements selected from group V elements.

**8.** A semiconductor device (1) according to any of claims 1 to 4, wherein the semiconductor device (1) is an n-type semiconductor device.

**9.** A semiconductor device (1) according to claim 8, wherein the first and second electrode (6) comprise Ytterbium silicide.

**10.** A semiconductor device (1) according to claim 8 or 9, wherein the semiconductor region (5) is uniformly doped with one or more dopant elements selected from group III elements.

**11.** A semiconductor device (1) according to any of the previous claims, wherein the semiconductor device is a transistor.

**12.** A semiconductor device (1) according to claim 11, wherein the first and second electrodes (6) are source and drain electrodes, wherein the third electrode (3) is a gate electrode and wherein the semiconductor region (5) is a channel.

**13.** A semiconductor device (1) according to any of the previous claims, wherein the semiconductor substrate (2) is a silicon substrate.

**14.** A method for manufacturing a semiconductor device comprising:

- providing first and second electrodes (6) in a semiconductor substrate (2) separated from each other by a semiconductor region (5), the semiconductor substrate having a doping level, and
- providing a third electrode (3) for controlling conductivity of the semiconductor region (5), at least one of the first and second electrodes (6) forming a rectifying contact with the semiconductor region (5), the rectifying contact having a potential barrier,

wherein the method furthermore comprises, before providing first, second and third electrodes (6, 3), uniformly doping the semiconductor region (5), at least in a direction between the first and the second electrodes to be provided, up to a doping level different from the doping level of the semiconductor substrate (2) such that, in operation, the potential barrier of the at least one rectifying contact is reduced by inducing an image-force mechanism.

**15.** A method according to claim 14, wherein uniformly doping the semiconductor region (5) is performed up to a doping level of between $1e16$ cm$^{-3}$ and $1e18$ cm$^{-3}$.

**16.** A method according to claim 14 or 15, wherein uniformly doping the semiconductor region (5) is performed by implanting dopant elements.

**FIG. 1**

| | | |
|---|---|---|
| PROVIDE A SEMICONDUCTOR SUBSTRATE | | 10 |
| FORM ISOLATION REGIONS IN THE SEMICONDUCTOR SUBSTRATE | | 20 |
| FORM WELL REGION IN THE SEMICONDUCTOR SUBSTRATE | | 30 |
| FORM GATE STACK | | 40 |
| FORM SIDEWALL SPACERS | | 50 |
| FORM METAL-SEMICONDUCTOR COMPOUND AT LEAST IN SOURCE/DRAIN REGIONS | | 60 |

**FIG. 2**

9

8

7                                                                    7

11                                                                   2

## FIG. 3

3

12

4

7                                                                    7

2

6          5          6

## FIG. 4

**FIG.5**

**FIG.6**

**FIG. 7**

**FIG. 8**

**FIG. 9**

**FIG. 10**

**FIG. 11**

**FIG. 12**

**FIG. 13**

**FIG. 14**

**FIG. 15**

**FIG. 16**

**FIG. 17**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6495882 B

**Non-patent literature cited in the description**

- **A. TANABE.** Influence of Fermi-level pinning on barrier height inhomogeneity in PtSi/p-Si Schottky contacts. *J. Appl. Phys.,* 1991, vol. 69 (2), 850-853
- **D. CONNELLY.** A new route to zero-barrier metal source/drain MOSFETs. *IEEE Trans on Nanotech,* 2004, vol. 3 (1), 98-104
- **Q. T. ZHAO.** Tuning of NiSi1Si Schottky barrier heights by sulfur segregation during Ni silicidation. *Appl. Phys. Lett.,* 2005, vol. 86, 062108
- **J. KNOCH.** Effective Schottky barrier lowering in silicon-on-insulator Schottky-barrier metal- oxide-semiconductor field-effect transistors using dopant segregation. *Appl. Phys. Len.,* 2005, vol. 87, 263505
- **NORDE et al.** A modified forward I-V plot for Schottky diodes with high series resistance. *J. Appl. Phys.,* 1979, vol. 50 (7), 5052-5053